# EUROPÄISCHE PATENTANMELDUNG

(11) **EP 1 450 439 A2**
(43) Veröffentlichungstag der Anmeldung: **25.08.2004**
(21) Anmeldenummer: 04002351.7
(22) Anmeldetag: 03.02.2004
(51) Int. Cl.: H01R 4/48

(54) **Planare Kontaktstruktur mit Kontaktzungen für eine variable Steckposition**

(30) Priorität: 18.02.2003 DE 10306618
(71) Anmelder: Tyco Electronics AMP GmbH, 64625 Bensheim (DE)
(72) Erfinder: Reissmann, Tobias, 01187 Dresden (DE)
(74) Vertreter: Patentanwaltskanzlei WILHELM & BECK

(57) **Zusammenfassung**

Die Erfindung beschreibt eine Kontaktanordnung zur Kontaktierung eines Kontaktstiftes, wobei als Kontaktelement zwei sich gegenüberstehende Reihen von Kontaktzungen verwendet werden.

Die Kontaktzungen einer Reihe erstrecken sich bis in Zwischenräume von Kontaktzungen der gegenüberliegenden Reihe.

Durch die Verwendung von Kontaktzungen, die sich über eine Mittenachse des Kontaktelementes erstrecken, ist eine elektrische Kontaktierung eines Kontaktstiftes mit guter Leitfähigkeit möglich, obwohl dessen Position seitlich aus der Mittenachse verschoben ist. Vorzugsweise stehen sich Reihen von unterschiedlich langen Kontaktzungen gegenüber, wobei einer kurzen Kontaktzunge einer ersten Reihe eine lange Kontaktzunge einer zweiten Reihe zugeordnet ist. Vorzugsweise sind zwei identisch aufgebaute Kontaktelemente übereinander angeordnet, wobei jeweils eine lange und eine kurze Kontaktzunge übereinander angeordnet sind. Die kurzen Kontaktzungen dienen zur Erhöhung der Anpresskraft der langen Kontaktzungen. Auf diese Weise kann eine verbesserte elektrische Kontaktierung von Kontaktstiften mit einer flexiblen Leiterplatte, insbesondere von elektrischen Relais mit einer flexiblen Leiterplatte erreicht werden.

## Beschreibung

Die Erfindung betrifft eine Kontaktstruktur mit Kontaktzungen gemäß dem Oberbegriff des Patentanspruchs 1.

Kontaktanordnungen zur Kontaktierung von Kontaktstiften werden in verschiedenen technischen Bereichen eingesetzt. In der Kraftfahrzeugtechnik werden beispielsweise flexible Leiterplatten eingesetzt, die Kontaktanordnungen aufweisen. Die Kontaktanordnungen dienen zur elektrischen Kontaktierung und mechanischen Halterung eines Kontaktstiftes. Der Kontaktstift ist Teil eines elektrischen Bauteils.

Aus US 3 768 062 ist eine flexible Leiterplatte bekannt, die elektrische Kontaktanordnungen mit Kontaktzungen zur elektrischen Kontaktierung von Kontaktstiften aufweist. Die elektrische Kontaktanordnung weist Befestigungslaschen auf, die durch die flexible Leiterplatte gestochen und umgebogen sind. Damit ist zum einen eine mechanische Halterung der Kontaktanordnung und zum anderen eine elektrisch leitende Verbindung zwischen einer Leiterbahn der flexiblen Leiterplatte und der Kontaktanordnung gegeben. Die Kontaktanordnung weist zwei parallel gegenüberliegende Kontaktzungen auf, die zur elektrischen Kontaktierung und mechanischen Halterung eines Kontaktstiftes dienen.

Aus US 4 056 299 ist eine elektrische Kontaktanordnung bekannt, die in Form einer elektrisch leitenden Platte mit einer Kontaktöffnung ausgebildet ist. Die Kontaktöffnung wird von gegenüberliegenden Kontaktzungen begrenzt. Die Kontaktanordnung ist in eine Halteplatte eingebracht, die ebenfalls Öffnungen im Bereich der Kontaktöffnungen der Kontaktanordnung aufweist. Die Kontaktzungen sind aus einem steifen Material hergestellt, so dass ein in die Kontaktanordnung eingeschobener Kontaktstift von den Kontaktzungen formschlüssig gehalten wird und zugleich eine elektrisch leitende Verbindung zwischen den Kontaktzungen und dem Kontaktstift ausgebildet ist. Die bekannten Kontaktanordnungen weisen den Nachteil auf, dass Abweichungen zwischen der Kontaktanordnung und den zu kontaktierenden Kontaktstiften nicht ausgeglichen werden können.

Die Aufgabe der Erfindung besteht darin, eine verbesserte Kontaktstruktur bereitzustellen, mit der eine Abweichung der Kontaktposition in zwei Richtungen toleriert wird.

Die Aufgabe der Erfindung wird durch die Kontaktstruktur gemäß Anspruch 1 gelöst. Ein wesentlicher Vorteil der erfindungsgemäßen Kontaktstruktur besteht darin, dass Kontaktstifte auch bei einer seitlichen Abweichung von einer optimalen mittigen Position in Bezug auf die Kontaktstruktur noch zuverlässig elektrisch leitend kontaktiert werden. Dieser Vorteil wird dadurch erreicht, dass sich die Kontaktzungen einer ersten Reihe bis zwischen die Kontaktzungen der gegenüberliegenden Reihe erstrecken. Auf diese Weise wird ein Kontaktstift auch dann noch sicher elektrisch kontaktiert, wenn der Kontaktstift nicht mittig zwischen den zwei gegenüberliegenden Reihen von Kontaktzungen angeordnet ist.

Weitere vorteilhafte Ausführungsformen der Erfindung sind in den abhängigen Ansprüchen angegeben.

Vorzugsweise sind die Kontaktzungen einer Reihe unterschiedlich lang ausgebildet. Die Verwendung von unterschiedlich langen Kontaktzungen bietet bei einer Abweichung der Position des Kontaktstiftes von der optimalen mittigen Position eine verbesserte elektrische Kontaktierung des Kontaktstiftes.

In einer weiteren bevorzugten Ausführungsform stehen sich jeweils eine lange und eine kurze Kontaktzunge der zwei Reihen gegenüber. In einer Reihe wechseln sich eine lange und eine kurze Kontaktzunge ab. Diese Ausführungsform stellt eine verbesserte Lösung für eine gute elektrische Kontaktierung und hohe Haltekräfte, mit denen ein Kontaktstift festgehalten wird, dar. Die kurzen Kontaktzungen kontaktieren einen eingesteckten Kontaktstift mit einer hohen Kontaktkraft, da die kurzen Kontaktzungen eine hohe Steifigkeit aufweisen. Dadurch wird eine sichere Kontaktierung des Kontaktstiftes bei einer großen Mittenabweichung der Lage des Kontaktstiftes ermöglicht.

In einer bevorzugten Ausführungsform der Erfindung sind zwei Kontaktzunge übereinander vorgesehen, wobei über einer Kontaktzunge eines unteren Kontaktelementes eine Kontaktzunge eines oberen Kontaktelementes angeordnet ist. Auf diese Weise wird eine mechanische Stabilisierung der Kontaktzungen des ersten Kontaktelementes durch die Kontaktzungen des zweiten Kontaktelementes erreicht. Somit werden erhöhte Haltekräfte bei der elektrischen Kontaktierung der Kontaktstifte erreicht. Besonders hohe Kontaktkräfte werden dadurch erreicht, dass die übereinander angeordneten Kontaktzungen jeweils Paare aus einer langen und einer kurzen Kontaktzunge bilden. Dadurch werden besonders gute Kontakteigenschaften erreicht.

Die Erfindung wird im Folgenden anhand der Figuren näher erläutert. Es zeigen
Fig. 1 eine erste Ausführungsform eines Kontaktelementes,
Fig. 2 eine zweite Ausführungsform eines Kontaktelementes,
Fig. 3 das erste Kontaktelement mit Klemmlaschen,
Fig. 4 eine Anordnung mit einem ersten und einem zweiten Kontaktelement,
Fig. 5 eine schematische Darstellung einer Kontaktanordnung mit einem ersten und einem zweiten Kontaktelement, in dem ein Kontaktstift eingeschoben ist,
Fig. 6 die Kontaktanordnung mit dem ersten und zweiten Kontaktelement und dem Kontaktstift von unten,
Fig. 7 eine schematische Darstellung einer flexiblen Leiterplatte mit einem elektrischen Bauteil, das über einen Kontaktstift mit der flexiblen Leiterplatte elektrisch kontaktiert ist, und
Fig. 8 einen Querschnitt durch eine flexible Leiterplatte, die über ein erstes und ein zweites Kontaktelement mit einem Kontaktstift elektrisch leitend verbunden ist.

Die erfindungsgemäße Kontaktanordnung wird im Folgenden näher erläutert.

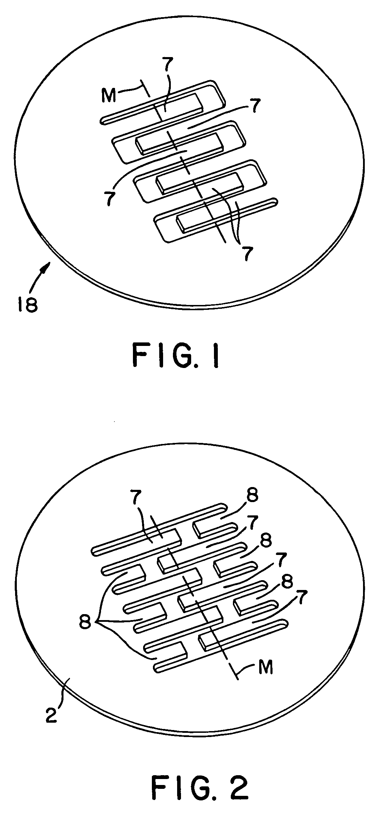

Fig. 1 zeigt ein drittes Kontaktelement 18, das eine erste Ausführungsform einer Kontaktstruktur mit sich gegenüber stehenden Kontaktzungen darstellt. In dieser Ausführungsform sind lange Kontaktzungen 7 angeordnet, wobei sich zwei Reihen von langen Kontaktzungen 7 gegenüberstehen und sich jeweils eine Kontaktzunge 7 einer ersten Reihe bis in den Zwischenraum zweier Kontaktzungen 7 der gegenüberliegenden Reihe erstreckt. In dieser Ausführungsform kann eine elektrische Kontaktierung eines Kontaktstiftes 3 erreicht werden, dessen Position von einer Mittenachse M seitlich abweicht.

Ein gültiger Steckbereich, in dem es frei wählbar ist, an welcher Position ein Kontaktstift in die Kontaktstruktur eintaucht, kann durch die Abmessungen eines rechteckigen Kontaktierbereiches auf die Kontaktieraufgabe angepasst werden. Prinzipiell können die zwei sich gegenüberstehenden Reihen von Kontaktzungen beliebig lang sein, so dass sich in dieser Richtung (=entlang der Mittellinie) ein sehr großer Steckbereich ergibt.

In der anderen Richtung ist der gültige Steckbereich durch die Länge der langen Kontaktzungen begrenzt. Zur Kontaktierung des Kontaktstiftes müssen die langen Zungen den Stift noch erreichen. In dieser Richtung ist der Steckbereich kleiner, da die Kontaktzungen aus Gründen einer noch ausreichend hohen Steifigkeit (Kontaktkraft) nicht beliebig lang ausgeführt werden können.

Dies stellt jedoch kein Problem dar, weil die Toleranz zwischen Kontaktpartnern in der Praxis in den zwei Hauptrichtungen meist unterschiedlich groß ausfallen. Durch entsprechend angepasste Orientierung der Struktur kann die Richtung mit der größeren Schwankung entlang der Mittellinie des Kontaktelements gelegen werden.

Fig. 2 zeigt eine zweite Ausführungsform einer Kontaktstruktur mit einem ersten Kontaktelement 2. In dieser Ausführungsform ist eine erste Reihe von langen und kurzen Kontaktzungen 7, 8 angeordnet, der gegenüberliegend eine zweite Reihe von langen und kurzen Kontaktzungen 7, 8 zugeordnet ist. Die erste und die zweite Reihe weisen abwechselnd kurze und lange Kontaktzungen 8, 7 auf. Dabei stehen kurze Kontaktzungen 8 der zweiten Reihe direkt den langen Kontaktzungen 7 der ersten Reihe gegenüber. Die langen Kontaktzungen 7 der zweiten Reihe stehen kurzen Kontaktlaschen 8 der ersten Reihe gegenüber. Auch in dieser Ausführungsform wird eine sichere elektrische Kontaktierung eines Kontaktstiftes 3 erreicht, dessen Position von einer Mittenachse M seitlich abweicht. Die langen Kontaktzungen 7 der ersten und der zweiten Reihe sind auch in dieser Ausführungsform bis über die Mittenachse M hinaus geführt. Die Ausführungsformen der Fig. 1 und 2 sind als Stanzteile ausgebildet.

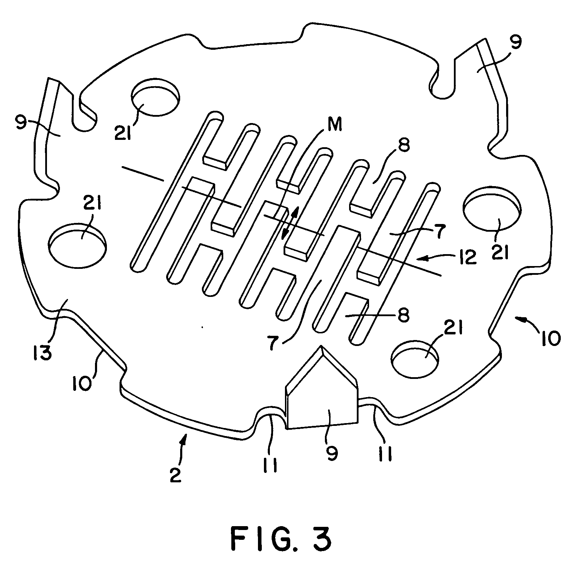

Fig. 3 zeigt eine perspektivische Darstellung einer Ausführungsform des ersten Kontaktelementes 2. Das erste Kontaktelement 2 ist vorzugsweise aus einem Stanzteil hergestellt. Als Material kommen dünne, elektrisch leitende Bleche in Frage. Vorzugsweise werden Kupfer-Nickel- und Kupfer-Zinn-Legierungen verwendet. Das erste Kontaktelement 2 weist im Wesentlichen eine Kreisscheibenform auf, in der mittig ein Kontaktfeld 12 angeordnet ist. Das Kontaktfeld 12 ist im Wesentlichen rechteckförmig ausgebildet und verfügt über zwei sich gegenüberstehende Reihen von Kontaktzungen 7, 8. In der dargestellten Ausführungsform wechseln sich in einer Reihe eine lange Kontaktzunge 7 mit einer kurzen Kontaktzunge 8 ab. Gegenüberliegend zu einer langen Kontaktzunge 7 einer ersten Reihe ist eine kurze Kontaktzunge 8 der gegenüberliegenden zweiten Reihe angeordnet. Die langen Kontaktzungen 7 erstrecken sich jeweils bis über eine Mittenachse M des Kontaktfeldes 12. Auf diese Weise erstreckt sich eine lange Kontaktzunge 7 ausgenommen von den Randbereichen jeweils zwischen zwei langen Kontaktzungen 7 der gegenüberliegenden Reihe. Die sich gegenüberstehenden langen und kurzen Kontaktzungen 7, 8 weisen einen gleichmäßigen Abstand voneinander auf. Die langen und kurzen Kontaktzungen 7, 8 sind im Wesentlichen als rechteckförmige Stege ausgebildet. Zwischen den Kontaktzungen 7, 8 einer Reihe ist seitlich jeweils ein Schlitz ausgebildet. Die Kontaktzungen 7, 8 sind einstückig mit einer Kontaktplatte 13 ausgebildet. Die Kontaktplatte 13 weist in der dargestellten Ausführungsform drei Klemmlaschen 9 auf, die jeweils um 120° zueinander versetzt am Außenumfang der Kontaktplatte 13 ausgebildet sind. Die Klemmlaschen 9 erstrecken sich ausgehend von einer Einbuchtung 11 in radialer Richtung aus dem Seitenrand der Kontaktplatte 13. Vorzugsweise weist die Kontaktplatte 13 gegenüberliegend zu jeder Klemmlasche 9 eine Laschenausnehmung 10 ausgebildet.

Aus der Kontaktplatte 13 sind vorzugsweise die langen und kurzen Kontaktzungen 7, 8 gebildet. Die langen und kurzen Kontaktzungen 7, 8 sind in der Weise dimensioniert, dass ein durch das Kontaktelement 2, 14 geschobener Kontaktstift 3 die langen Kontaktzungen 7 und die kurzen Kontaktzungen 8 wegbiegen kann, wobei jedoch die Kontaktzungen 7, 8 an dem Kontaktstift 3 mit einer Vorspannkraft anliegen und sicher ein elektrischer Kontakt zwischen den Kontaktzungen 7, 8 und dem Kontaktstift 3 hergestellt ist. Durch die Ausbildung der langen und kurzen Kontaktzungen 7, 8 ist eine elektrische Kontaktierung des Kontaktstiftes 3 auch dann noch gut möglich, wenn der Kontaktstift 3 von der Mittenachse M, die in Form einer gestrichelten Linie angedeutet ist, seitlich abweicht. Die seitliche Abweichung ist in Form eines Doppelpfeiles dargestellt. In einer einfachen Ausführungsform ist nur ein einziges erstes Kontaktelement 2 angeordnet. Auch ein einziges Kontaktelement 2 ermöglicht eine relativ gute elektrische Kontaktierung eines Kontaktstiftes 3.

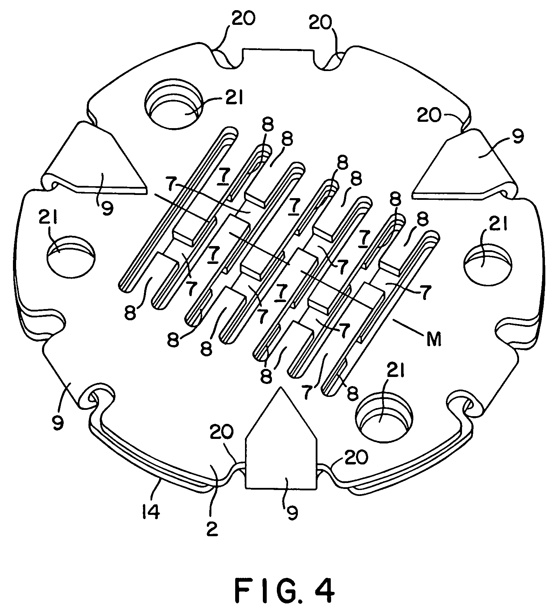

Die elektrische Kontaktierung wird jedoch in vorteilhafter Weise dadurch verbessert, dass, wie in Fig. 4 dargestellt ist, ein erstes und ein zweites Kontaktelement 2, 14 übereinander angeordnet sind. Dabei sind jeweils übereinander eine lange und eine kurze bzw. eine kurze und eine lange Kontaktzunge 7, 8 angeordnet. Die Kontaktplatte 13 weist Bohrungen 21 auf, die zur Justierung dienen.

Fig. 4 zeigt eine schematische Darstellung einer Kontaktstruktur mit einem ersten und einem zweiten Kontaktelement 2, 14, die miteinander verbunden sind. Das erste und das zweite Kontaktelement sind in der dargestellten Ausführungsform identisch ausgebildet, wobei jedoch das erste und das zweite Kontaktelement um 180° zueinander verdreht angeordnet sind. Auf diese Weise greifen die Klemmlaschen 9 des ersten Kontaktelementes 2 in Laschenausnehmungen 10 des zweiten Kontaktelementes 14 ein und umgekehrt. Die Bohrungen 21 dienen dabei als Justierhilfe für eine exakte Ausrichtung des ersten und des zweiten Kontaktelementes 2, 14 zueinander. Damit wird die Justierung des ersten und zweiten Kontaktelementes 2, 14 vereinfacht. In Fig. 4 ist deutlich erkennbar, dass kurze und lange Kontaktzungen 7, 8 übereinander angeordnet sind.

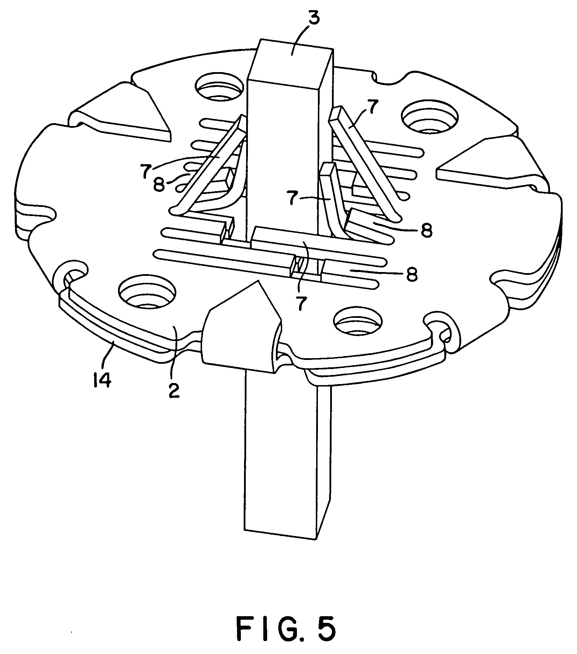

Fig. 5 zeigt eine schematische Darstellung einer Kontaktstruktur mit einem ersten und einem zweiten Kontaktelement 2, 14. Fig. 5 zeigt einen Kontaktstift 3, der durch die Kontaktstruktur von unten hindurchgeschoben ist. Die Breite des Kontaktstiftes 3 ist in der Weise bemessen, dass mindestens zwei nebeneinander angeordnete lange Kontaktzungen 7 an einer Seitenfläche des Kontaktstiftes 3 zur Anlage gelangen. In dem dargestellten Ausführungsbeispiel liegen vier lange Kontaktzungen 7 an dem Kontaktstift 3 an. Auf der rechten Seite ist eine lange Kontaktzunge 7 Teil des unteren zweiten Kontaktelementes 14 und eine mittig angeordnete, lange Kontaktzunge 7 ist Teil des oberen, ersten Kontaktelementes 2. Den langen Kontaktzungen 7 des zweiten Kontaktelementes 14 sind kurze Kontaktzungen 8 des ersten Kontaktelementes 2 zugeordnet. Die langen Kontaktzungen 7 liegen an der Seitenwand des Kontaktstiftes 3 an. Die oberen, kurzen Kontaktzungen 8 liegen auf den unteren, langen Kontaktzungen 7 auf und sind ebenfalls nach oben gebogen. Die kurzen Kontaktzungen 8 erhöhen die Anpresskraft der langen Kontaktzungen 7 an dem Kontaktstift 3. Somit gleichen die kurzen Kontaktzungen die geringere Federsteifigkeit der langen Kontaktzungen aus. Bei dieser Anordnung sind einzelne kurze Kontaktzungen des unteren, zweiten Kontaktelementes 14 nicht in elektrischem Kontakt zum Kontaktstift 3. Wesentlich ist, dass die langen Kontaktzungen 7 des unteren, zweiten Kontaktelementes 14 durch die kurzen Kontaktzungen 8 des oberen, ersten Kontaktelementes 2 in der Federsteifigkeit unterstützt werden. Aufgrund der langen, sich seitlich überlappenden Kontaktzungen 7 wird eine seitliche Abweichung der Anordnung des Kontaktstiftes 3 von der Mittenachse M ausgeglichen. Somit kann der Kontaktstift 3 in einem großen Bereich des Kontaktfeldes 12 eingesteckt und sicher kontaktiert werden. Somit ist die Steckposition in einem relativ großen Bereich frei wählbar.

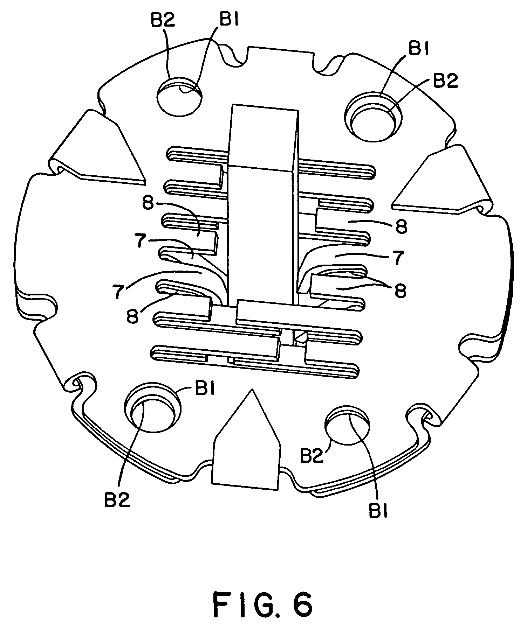

Fig. 6 zeigt die Anordnung von Fig. 5 von der Unterseite, d.h. von der Einschubrichtung des Kontaktstiftes 3. Dabei ist deutlich die Anlage der langen Kontaktzungen 7 am Kontaktstift 3 und das Nichtanlegen der kurzen Kontaktzungen 8 des unteren, zweiten Kontaktelementes 14 zu erkennen. Für eine sichere Kontaktierung ist es auch nicht erforderlich, dass die kurze Federzunge 8 auf der Einsteckseite des Kontaktstiftes 3 am Kontaktstift 3 anliegen. Die kurzen Federzungen dienen im Wesentlichen dazu, die langen Federzungen 7 in der Steifigkeit zu unterstützen und in Richtung auf den Kontaktstift 3 vorzuspannen. In einer bevorzugten Ausführungsform sind auf einem Kontaktelement 2, 14 zwei Bohrungspaare B1, B2 angeordnet, deren Bohrungen 21 unterschiedlich große Durchmesser aufweisen. Die Bohrungen 21 des zweiten Bohrungspaares B2 haben einen kleineren Durchmesser als die Bohrungen des ersten Bohrungspaares B1.

Dadurch, dass die beiden Kontaktelemente zueinander um 180° gedreht sind, liegen einem zweiten Bohrungspaar B2 mit kleinen Durchmesser eines Kontaktelementes einem ersten Bohrungspaar B1 mit großem Durchmesser des anderen Kontaktelement gegenüber. Zwei Aufnahmestifte des Montagekopfes greifen immer nur in die beiden kleinen Bohrungen ein und können dann in die großen Bohrungen des zweiten Elements ohne zu klemmen eintauchen. Das ist notwendig, da die beiden Kontaktelemente im montierten Zustand zur einen Abstand von 0,1 mm voneinander haben.

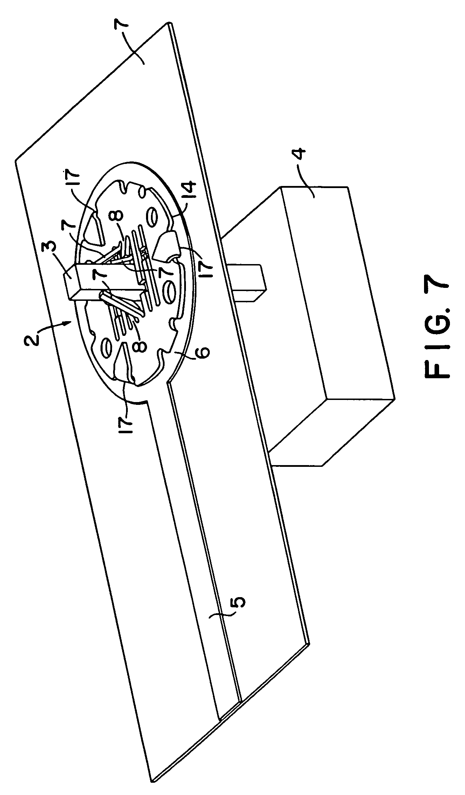

Fig. 7 zeigt einen Ausschnitt aus einer flexiblen Leiterplatte 1, die eine elektrische Leiterbahn 5 aufweist. Die elektrische Leiterbahn 5 steht in elektrisch leitendem Kontakt mit einer Kontaktstruktur, die ein erstes und ein zweites Kontaktelement 2, 14 aufweist. Die elektrische Leiterbahn 5 mündet in diesem Ausführungsbeispiel in einen Leiterring 6, der elektrisch leitend mit dem ersten und dem zweiten Kontaktelement 2, 14 verbunden ist. Die Kontaktanordnung dient zur elektrischen Kontaktierung eines Kontaktstiftes 3, der Teil eines elektrischen Bauteils 4 ist. Die Kontaktstruktur weist die elektrisch leitenden und mechanisch biegbaren Kontaktzungen 7, 8 auf, die am Kontaktstift 3 mit einer Anpresskraft anliegen und den Kontaktstift 3 elektrisch leitend mit der Leiterbahn 5 verbinden. Auf diese Weise wird eine elektrisch leitende Verbindung zwischen der Leiterbahn 5 und dem elektrischen Bauteil 4 hergestellt.

Der Kontaktstift 3 weist vorzugsweise einen rechteckigen Querschnitt auf und stellt beispielsweise einen Anschlussdraht für das elektrische Bauteil 4 auf. Das elektrische Bauteil 4 kann jede Art eines elektrischen Bauteiles, insbesondere aber eine Relaisspule darstellen, deren Spulenanschlüsse über Kontaktstifte 3 elektrisch leitend mit der flexiblen Leiterplatte 1 verbunden werden. Die elektrisch leitende Verbindung ist durch einen einfachen Einsteckvorgang des Kontaktstiftes 3 in die Kontaktanordnung herstellbar. Die Stecktiefe des Kontaktstiftes 3 kann aufgrund der vorteilhaften Ausführungsform der Kontaktelemente 2, 14 in einem weiten Bereich variieren. Aufgrund der Kontaktzungen 7, 8, die in Form eines Lamellengitters angeordnet sind, können in zwei Richtungen relativ große seitliche Abweichungen der Einsteckposition des Kontaktstiftes 3 von einer mittigen optimalen Lage ausgeglichen werden. Die Kontaktelemente 2, 14 weisen Klemmlaschen 9 auf, die durch den Leiterring 6 und die isolierende Leiterplatte 1 gestochen und auf der anderen Seite umgebogen sind. Auf diese Weise wird zum einen ein elektrisch leitender Kontakt zwischen dem Leiterring 6 und den Kontaktelementen 2, 14 hergestellt und zum anderen eine mechanische Halterung der Kontaktelemente 2, 14 an der Leiterplatte 1 bzw. eine mechanische Halterung des ersten Kontaktelementes 2 am zweiten Kontaktelement 14 erreicht. Die Klemmlaschen 9 des ersten Kontaktelementes 2 liegen auf dem zweiten Kontaktelement 14 auf. Genauso liegen umgekehrt die Klemmlaschen 9 des zweiten Kontaktelementes 14 auf dem ersten Kontaktelement 2 auf.

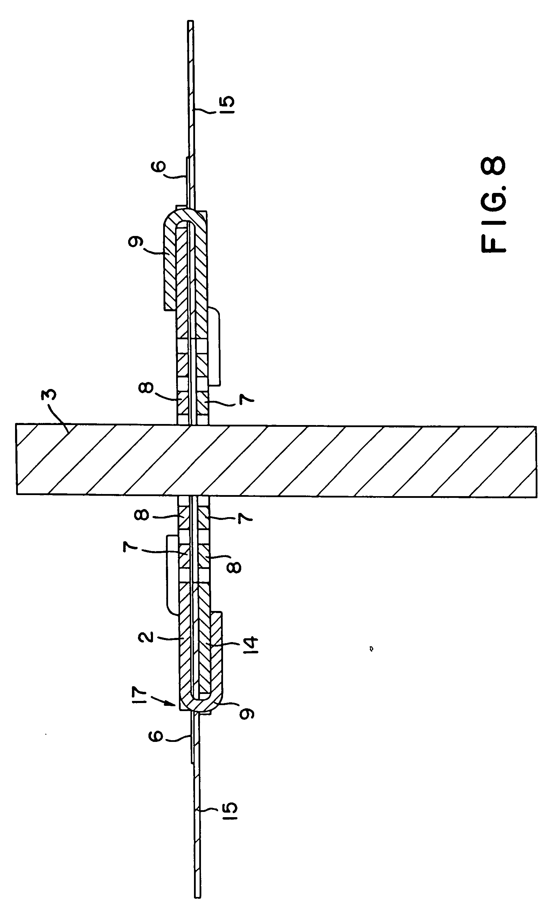

Fig. 8 zeigt einen Querschnitt durch die Anordnung der Fig. 7, wobei der Aufbau der flexiblen Leiterplatte 1 und die elektrische Kontaktierung des ersten und des zweiten Kontaktelementes 2, 14 mit dem Leiterring 6 deutlich erkennbar ist. Im inneren Bereich des Leiterringes 6 liegt das erste Kontaktelement 2 auf dem Leiterring 6 auf. Die Klemmlaschen 9 des ersten Kontaktelementes 2 sind durch den Leiterring 6 und die Leiterplatte 1 gestochen und auf der unteren Seite in Laschenausnehmungen 10 des zweiten Kontaktelementes 14 umgebogen und liegen auf der Außenfläche des zweiten Kontaktelementes 14 auf. Das zweite Kontaktelement 14 liegt auf der Unterseite der Leiterplatte 1 auf, die elektrisch isolierend ausgebildet ist. Ebenso sind die Klemmlaschen 9 des zweiten Kontaktelementes 14 durch die Leiterplatte 1 und den Leiterring 6 gestochen und durch Laschenausnehmungen 10 des ersten Kontaktelementes 2 geführt. Die Klemmlaschen 9 des zweiten Kontaktelementes 14 sind umgebogen und liegen auf der Außenfläche des ersten Kontaktelementes 2 auf. Auf diese Weise sind das erste und das zweite Kontaktelement 2, 14 sowohl elektrisch leitend mit dem Leiterring 6 und damit mit der Leiterbahn 5 verbunden, als auch mechanisch miteinander und mit der flexiblen Leiterplatte 1 gehaltert. Die Kontaktzungen 7, 8 des oberen ersten Kontaktelementes 2 sind über den Kontaktzungen 8, 7 des unteren zweiten Kontaktelementes 14 angeordnet. Die Klemmlaschen 9 stechen Stichlöcher 17 in die Leiterplatte 1 und sind durch die Stichlöcher 17 durch die Leiterplatte 1 und den Leiterring 6 geführt.

Vorzugsweise weist ein Kontaktstift 3 einen rechteckförmigen Querschnitt auf, dessen Querschnittsfläche kleiner als 0,5 mm ist. Vorzugsweise ist der Durchmesser einer Kontaktplatte 13 kleiner als 5 mm. Durch die Verwendung zweier identisch aufgebauter Kontaktelemente 2, 14 ist eine kostengünstige Herstellung der Kontaktanordnung möglich. Durch die Versteifung der langen Kontaktzungen 7 des zweiten Kontaktelementes 14 durch die kurzen Kontaktzungen 8 des ersten Kontaktelementes 2 wird die Kontaktkraft der langen Kontaktzungen 7 fast verdoppelt. Zudem erhöht sich durch die Anordnung zweier übereinander angeordneter Kontaktelemente 2, 14 die Anzahl der elektrischen Kontakte. Dadurch wird die Zuverlässigkeit der elektrischen Kontaktierung zudem verbessert.

Der gesamte Herstellungs- und Montageprozess der erfindungsgemäßen Kontaktanordnung ist vollautomatisierbar und besteht nur aus wenigen Prozessschritten. Das Fügen der beiden Kontaktelemente 2, 14 zu der Kontaktanordnung kann durch Bewegung eines Fügekopfes in nur einer Achse erfolgen. Das Schließen der Laschenverbindung lässt sich durch eine Integration von drei kleinen, seitlich beweglichen Stempeln direkt in den Fügekopf auf einfache Art und Weise realisieren. Ein derart schmal bauender Fügekopfaufbau erlaubt es, falls erforderlich, mehrere Kontaktzungenkontakte in engem Abstand zueinander beispielsweise auf einer flexiblen Leiterplatte 1 zu befestigen. Dies ermöglicht eine Anordnung der Kontaktanordnungen zu einem Array von einer Vielzahl von Kontaktanordnungen.

Die Einsatzmöglichkeit der erfindungsgemäßen Kontaktanordnung ist in keinster Weise auf Verbindungen im Automobil in Kombinationen mit elektrischen Relais beschränkt. Prinzipiell ist ein Einsatz zur Lösung aller Kontaktieraufgaben zwischen stiftförmigen, rechteckigen Anschlussstrukturen und einem Kontaktelement, insbesondere einer flexiblen Leiterplatte möglich.

### Bezugszeichenliste

- 1: Leiterplatte
- 2: Kontaktelement
- 3: Kontaktstift
- 4: elektrisches Bauteil
- 5: Leiterbahn
- 6: Leiterring
- 7: lange Kontaktzunge
- 8: kurze Kontaktzunge
- 9: Klemmlasche
- 10: Laschenausnehmung
- 11: Einbuchtung
- 12: Kontaktfeld
- 13: Kontaktplatte
- 14: zweites Kontaktelement
- 17: Stichloch
- 18: drittes Kontaktelement
- 20: Seitenwand
- 21: Bohrung

## Patentansprüche

1. Kontaktstruktur mit einem Kontaktelement (2) zur elektrischen Kontaktierung eines Kontaktstiftes,
wobei das Kontaktelement (2) wenigstens zwei sich gegenüberstehende Reihen von flexiblen Kontaktzungen (7, 8) vorgesehen sind,
**dadurch gekennzeichnet,**
**dass** sich die Kontaktzungen (7) einer ersten Reihe bis zwischen die Kontaktzungen (7) der gegenüberliegenden Reihe erstrecken, und
**dass** wenigstens die Kontaktzungen (7) einer Reihe bis über eine Mittenachse (M) der sich gegenüberstehenden Reihen von Kontaktzungen (7) erstrecken.

2. Kontaktstruktur nach Anspruch 1, **dadurch gekennzeichnet, dass** die Kontaktzungen (7, 8) einer Reihe unterschiedlich lang ausgebildet sind.

3. Kontaktstruktur nach Anspruch 2, **dadurch gekennzeichnet, dass** sich die Kontaktzungen (7, 8) der zwei Reihen gegenüberstehen,
dass wenigstens die Kontaktzungen (7, 8) einer ersten Reihe abwechselnd lang und kurz ausgebildet sind, und
dass einer kurzen Kontaktzunge (8) der ersten Reihe eine lange Kontaktzunge (7) der zweiten Reihe und einer langen Kontaktzunge (7) der ersten Reihe eine kurze Kontaktzunge (8) der zweiten Reihe gegenüberstehen.

4. Kontaktstruktur nach einem der Ansprüche 1 bis 3, **dadurch gekennzeichnet,**
**dass** ein zweites Kontaktelement (14) über dem ersten Kontaktelement (2) angeordnet ist,
**dass** das zweite Kontaktelement (14) zwei sich gegenüberstehende Reihen von Kontaktzungen (7, 8) aufweist,
**dass** die Kontaktzungen (7, 8) des zweiten Kontaktelementes wenigstens teilweise unter den Kontaktzungen (7, 8) des ersten Kontaktelementes (2) angeordnet sind.

5. Kontaktstruktur nach Anspruch 4, **dadurch gekennzeichnet, dass** einer kurzen Kontaktzunge (8) des unteren, zweiten Kontaktelementes (14) eine lange Kontaktzunge (7) des oberen, zweiten Kontaktelementes (2) zugeordnet ist, und
dass einer langen Kontaktzunge (7) des unteren, zweiten Kontaktelementes (14) eine kurze Kontaktzunge (8) des oberen, ersten Kontaktelementes (2) zugeordnet ist.

6. Kontaktstruktur nach einem der Ansprüche 1 bis 5, **dadurch gekennzeichnet,**
**dass** das erste und zweite Kontaktelement (2, 14) Klemmlaschen (9) aufweist,
**dass** die Klemmlaschen (9) durch eine flexible Leiterplatte (1) gesteckt und umgebogen sind und dadurch eine elektrisch leitende Verbindung zwischen einer Leiterbahn (6) der Leiterplatte (1) und dem Kontaktelement (2, 14) hergestellt ist.

7. Kontaktstruktur nach einem der Ansprüche 4 bis 6, **dadurch gekennzeichnet,**
**dass** das erste und zweite Kontaktelement identisch ausgebildet sind, und
**dass** das erste Kontaktelement (2) um 180° gegenüber dem zweiten Kontaktelement (14) gedreht angeordnet ist.

8. Kontaktstruktur nach einem der Ansprüche 1 bis 7, **dadurch gekennzeichnet,**
**dass** das erste Kontaktelement (2) Bohrung (21) aufweist,
**dass** das zweite Kontaktelement (14) Bohrungen (21) aufweist, und dass das erste und zweite Kontaktelement (2, 14) durch die Bohrung (21) symmetrisch zueinander justiert werden, indem die Bohrung (21) in Überdeckung angeordnet sind und die Federzungen der zwei Kontaktelemente parallel zueinander angeordnet sind.

9. Kontaktstruktur nach einem der Ansprüche 4 bis 8, **dadurch gekennzeichnet, dass** die Kontaktelemente (2, 14) zwei jeweils diagonal angeordnete Bohrungspaare (21) aufweisen, dass die Bohrungen (21) der zwei Bohrungspaare unterschiedlich große Durchmesser aufweisen, die bei der Montage in die flexible Leiterplatte zum Transportieren und Zentrieren der beiden Kontaktelemente (2, 14) dienen.
